# EUROPEAN PATENT APPLICATION

(11) **EP 1 536 580 A2**
(43) Date of publication of application: **01.06.2005**
(21) Application number: 04256386.6
(22) Date of filing: 16.10.2004
(51) Int. Cl.: H04H 1/00, G08G 1/09, H03J 1/00

(54) **Multiplex broadcast receiving apparatus and multiplex broadcast receiving method**

(30) Priority: 27.11.2003 JP 2003397603
(71) Applicant: Alpine Electronics, Inc., Tokyo 104 (JP)
(72) Inventor: Katsuki, Kiyoshi, c/o Alpine Electronics Inc., Iwaki-city, Fukushima (JP)
(74) Representative: Kensett, John Hinton

(57) **Abstract**

A multiplex broadcast receiving apparatus (1) includes a main tuner (4) for receiving a program broadcast multiplexed with a multiplexed broadcast wave; a sub-tuner (5) for receiving road traffic information, multiplexed with the multiplexed broadcast wave, which is transmitted at a predetermined interval; and a control section (9) for checking a state in which an alternative station frequency of the same program broadcast as that which is being received by the main tuner (4) is received while the sub-tuner (5) does not receive the road traffic information and for enabling the main tuner (4) to follow up on the alternative station frequency in which the receiving state is satisfactory. The control section (9) changes the period in which the follow-up operation is performed in accordance with the transmission interval of the road traffic information.

## Description

### BACKGROUND OF THE INVENTION

### 1. Field of the Invention

The present invention relates to a multiplex broadcast receiving apparatus and a multiplex broadcast receiving method.

### 2. Description of the Related Art

In recent years, traffic information broadcast stations for broadcasting traffic information broadcast programs for providing traffic information have been used. These traffic information broadcast stations not only broadcast traffic information programs, but also broadcast normal broadcast programs. As such traffic information broadcasts, for example, there is an RDS (Radio Data System) broadcast, which has been put into practical use mainly in various parts of Europe. The RDS broadcast is such that, in addition to broadcast-program-related data related to traffic information, data, such as broadcast-program-related information related to a normal broadcast program, is multiplexed with a normal FM broadcast wave, and the reception side analyzes this multiplexed data, thereby providing various services to listeners of the radio broadcast.

This RDS broadcast is particularly effective in an area where, mainly, many broadcast stations are networked to broadcast the same program. More specifically, a 57 kHz wave, which is the third-order harmonic of a stereo pilot signal of 19 kHz, is made to be a sub-carrier wave. The sub-carrier wave is amplitude-modulated in accordance with a data signal indicating filtered and bi-phase coded program-related information and traffic-information-related data, generating a radio data signal (hereinafter referred to as "RDS data"). The amplitude-modulated sub-carrier wave is frequency-converted into a main carrier wave, and is broadcast.

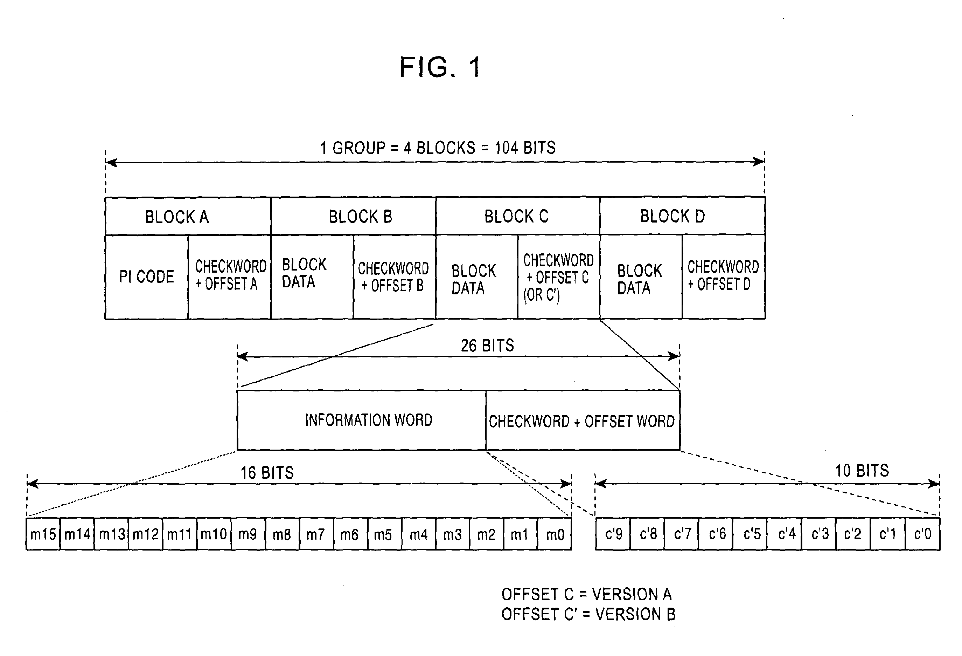

The basic baseband coding structure of the RDS data is described below with reference to Fig. 1.

Fig. 1 shows the baseband coding structure of the RDS data. As shown in Fig. 1, the RDS data is formed in units of groups in which 104 bits is one group. Each group is made up of four blocks (A, B, C, D), and each block is composed of a 16-bit information word (m0 to m15), a 10-bit checkword, and an offset word (C'0 to C'9). The transmission rate of the RDS data is 1187.5 bits/second.

In the block A, program identification data (program identification (PI) code) indicating a network, which is made up of country name data and program data, is arranged. In the block B, traffic information broadcast station identification data (traffic program (TP) identification code) indicating that it is a traffic information broadcast station for broadcasting a traffic information program, and traffic announcement identification data (traffic announcement (TA) code) indicating that a broadcast program related to the traffic information is to begin, are arranged. In the block C, data related to the frequency of each station of a group of network stations that broadcast the same program, that is, alternative station frequency data (alternative frequency (AF) code), is arranged. In the block D, broadcast station name data (program service (PS) code), such as the broadcast station name and the network name, is arranged. The PI code is made up of three elements, that is, 4-bit country name data, 4-bit area data, and 8-bit program data.

Each group is divided into 16 kinds of types 0 to 15 in units of 4 bits according to the content. Furthermore, for each group, two versions (A, B) are defined in such a manner as to correspond to each type (0 to 15), and the identification codes thereof are arranged in the block B. For the type defined in version A, the PI code is always contained in block A, but for the type defined in version B, the PI code is also contained in the block C in addition to the block A.

According to such a radio receiving apparatus for receiving RDS data, for example, when the receiving level in a broadcast station which is being currently received is lowered due to disturbances such as multi-path interference, by selecting another network station (alternative station) in which the receiving level is satisfactory on the basis of the AF data (automatic follow-up function), it is possible to provide, to users, a broadcast of the same program in which the receiving state is satisfactory without being influenced by disturbances. Furthermore, by identifying a traffic information broadcast station in accordance with the TP code, by identifying the fact that a traffic information program is broadcast in accordance with the TA code, and by displaying these identification notifications on the display section of the receiving apparatus, it is possible for a driver desiring traffic information to recognize the traffic information broadcast station and the starting of the program broadcast. This is very convenient.

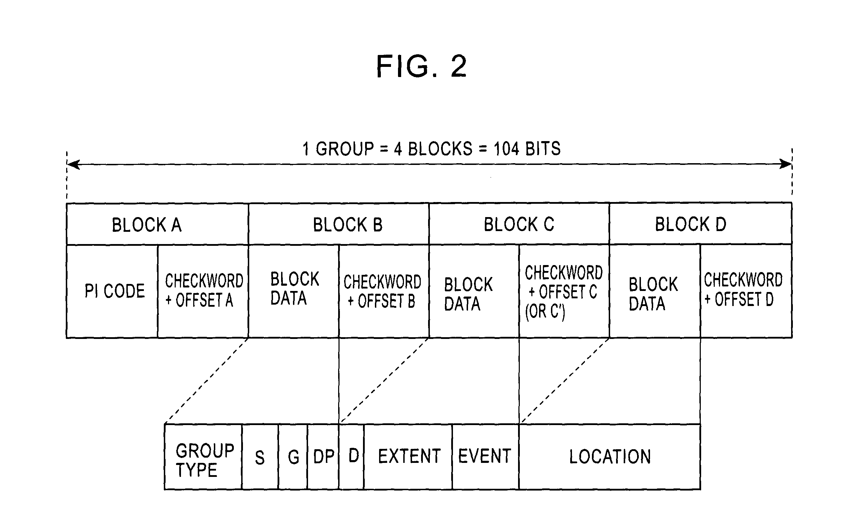

Furthermore, a TMC (Traffic Message Channel) using the RDS broadcast has been proposed. The TMC performs a broadcast by using, for example, a group 8A (that is, a group 8 defined in version A) in the RDS data. The baseband coding structure of the group 8A for transmitting the TMC will now be described with reference to Fig. 2.

Fig. 2 shows the baseband coding structure in the group 8A. As shown in Fig. 2, in the block A, the PI code is contained. In the block B, in addition to a 4-bit group type identification code for identifying the group 8A type, various codes for the management of messages and the expansion system are contained. For example, the block an has a 1-bit short message code S indicating that it is a short message, a 1-bit group message identification code indicating whether or not one message is a single group message transmitted as one group data or whether or not one message is transmitted over a plurality of pieces of group data, and a 3-bit traffic jam time code DP indicating an overall traffic jam time. The traffic jam time code DP is used to indicate a traffic jam time at eight stages (0 to 4 hours)

The block C has, for example, a detour identification code D indicating the presence or absence of a detour, a 3-bit extent code containing a location offset address, and an 11-bit event code indicating information, such as weather conditions, construction work, and a traffic jam. The block D has a 16-bit location code indicating positional information. If an expansion system using these codes are used, for example, various pieces of information that appropriately indicates a detour for a traffic jam are transmitted.

According to such a radio receiving apparatus for receiving the TMC data (TMC-compatible receiving apparatus), the TMC data itself, which is transmitted even if there is no broadcast program for traffic information, is traffic information. Therefore, by receiving the transmitted TMC data and sequentially storing it in advance, a situation in which the broadcast program being listened to is interrupted halfway can be resolved. In the TMC, the number of groups that are broadcast per second is 11.5. When the TMC data, which is the group 8A, is transmitted, even 100 continuous messages having a large amount of traffic information related to traffic jams which occur frequently during commutation and in holidays are transmitted in about one and half minutes. Therefore, it is possible to provide detailed traffic information to users substantially in real time.

By sequentially storing the TMC data which is transmitted, it is possible for the user to obtain the traffic information at each desired point when the user desires. Thus, poorness of the ease of operation such that traffic information of a desired area must be obtained while listening to the traffic information in areas other than the desired area by listening to a traffic information program as in a conventional case, can be overcome.

In the RDS, in order to receive the TMC data (group 8A), which is traffic information, it is common practice that a main tuner and a sub-tuner are used, that is, the main tuner receives the broadcast station desired by the user, and the sub-tuner receives the TMC station. As such conventional technology, a multiplex broadcast receiving apparatus disclosed in Japanese Unexamined Patent Application Publication No. 11-251940 has been proposed.

The multiplex broadcast receiving apparatus disclosed in Japanese Unexamined Patent Application Publication No. 11-251940 includes first and second tuners. While the first tuner receives multiplexed broadcast waves containing a program broadcast and data multiplexed with the program broadcast, the second tuner checks the state in which the alternative station frequency of the same program broadcast as that which is being received by the first tuner, and the first tuner follows up on the alternative station frequency whose receiving state is satisfactory.

As another conventional technology, the system disclosed in Japanese Unexamined Patent Application Publication No. 2002-26753 has been proposed. In the system disclosed in Japanese Unexamined Patent Application Publication No. 2002-26753, while the navigation apparatus is making an information guide for a user, the TMC data is extracted by the radio receiving apparatus. Therefore, even when a single tuner receives a broadcast, the TMC data can be received without subjecting the user to an uncomfortable feeling.

However, in the multiplex broadcast receiving apparatus disclosed in Japanese Unexamined Patent Application Publication No. 11-251940, an automatic follow-up operation can be performed using two tuners. However, there are problems in that, when road traffic information is received, another tuner is necessary.

Furthermore, in the multiplex broadcast receiving apparatus disclosed in Japanese Unexamined Patent Application Publication No. 11-251940, a single tuner receives a program and TMC data, which is road traffic information. However, since the TMC data is not received at every predetermined interval, there are problems in that all the TMC data cannot be received.

### SUMMARY OF THE INVENTION

Accordingly, the present invention has been made to solve these problems. An object of the present invention is to provide a multiplex broadcast receiving apparatus and a multiplex broadcast receiving method, which are capable of handling both a follow-up operation and the reception of traffic information.

To achieve the above-mentioned object, in one aspect, the present invention provides a multiplex broadcast receiving apparatus for receiving a multiplexed broadcast wave, including: a first tuner for receiving a program broadcast that is multiplexed with the multiplexed broadcast wave; a second tuner for receiving road traffic information, multiplexed with the multiplexed broadcast wave, which is transmitted at a predetermined interval; and a control section for enabling the second tuner to check a state in which an alternative station frequency of the same program broadcast as that which is being received by the first tuner is received in accordance with the transmission interval of the road traffic information and for enabling the first tuner to follow up on an alternative station frequency at which the receiving state is satisfactory. According to the present invention, since the follow-up operation is performed while the second tuner does not receive the road traffic information, it is possible to handle both the follow-up operation and the reception of the road traffic information.

In the above-described configuration of the present invention, the control section may obtain gap data indicating the transmission interval of the road traffic information and may change the follow-up operation in accordance with the gap data. According to the present invention, since the follow-up operation is changed in accordance with the gap data, even when the transmission interval of the road traffic information is changed on the broadcast station side, it is possible to handle both the follow-up operation and the reception of the road traffic information.

In the above-described configuration of the present invention, when the transmission interval of the road traffic information is not known, the control section may enable the second tuner to repeatedly receive the road traffic information and to check the receiving state. According to the present invention, even when the transmission interval of the road traffic information is not known, it is possible to handle both the follow-up operation and the reception of the road traffic information.

In the above-described configuration of the present invention, when the transmission interval of the road traffic information is exceeded while program identification data is being analyzed by the second tuner during the follow-up operation, the control section may continue to enable the second tuner to receive the road traffic information until the next road traffic information is transmitted. According to the present invention, it is possible to handle both the analysis of the program identification data required for the follow-up operation and the reception of the road traffic information.

In the above-described configuration of the present invention, when the follow-up operation in accordance with the transmission interval of the road traffic information is being performed, the control section may cancel the follow-up operation in accordance with the transmission interval of the road traffic information when data other than data on the road traffic information or the transmission interval of the road traffic information is received continuously a predetermined number of times. According to the present invention, even when the transmission interval of the road traffic information cannot be trusted, it is possible to handle both the reception of the road traffic information and the follow-up operation.

In another aspect, the present invention provides a multiplex broadcast receiving method for receiving a multiplexed wave, including a first step in which a first tuner receives a program broadcast multiplexed with the multiplexed broadcast wave; a second step in which a second tuner receives road traffic information, multiplexed with the multiplexed broadcast wave, which is transmitted at a predetermined interval; and a third step in which the second tuner checks a state in which an alternative station frequency of the same program broadcast as that which is being received by the first tuner is received in accordance with the transmission interval of the road traffic information, and the first tuner follows up on an alternative station frequency at which the receiving state is satisfactory. According to the present invention, since the follow-up operation is performed while the second tuner does not receive the road traffic information, it is possible to handle both the follow-up operation and the reception of the road traffic information.

In the above-described configuration of the present invention, the third step may include a step of obtaining gap data indicating the transmission interval of the road traffic information and changing the follow-up operation in accordance with the gap data. According to the present invention, since the follow-up operation is changed in accordance with the gap data, even when the transmission interval of the road traffic information is changed on the broadcast station side, it is possible to handle both the follow-up operation and the reception of the road traffic information.

In the above-described configuration of the present invention, the third step may include a step in which, when the transmission interval of the road traffic information is not known, the second tuner repeatedly receives the road traffic information and checks the receiving state at a predetermined interval. According to the present invention, even when the transmission interval of the road traffic information is not known, it is possible to handle both the follow-up operation and the reception of the road traffic information.

In the above-described configuration of the present invention, the third step may include a step in which, when the transmission interval of the road traffic information is exceeded while program identification data is being analyzed by the second tuner during the follow-up operation, the second tuner receives the road traffic information when the next road traffic information is transmitted. According to the present invention, it is possible to handle both the analysis of the program identification data required for the follow-up operation and the reception of the traffic information.

In the above-described configuration of the present invention, the third step may include a step in which, when the follow-up operation in accordance with the transmission interval of the road traffic information is being performed, the follow-up operation in accordance with the transmission interval of the road traffic information is cancelled when data other than data on the road traffic information or the transmission interval of the road traffic information is received continuously a predetermined number of times. According to the present invention, even when the transmission interval of the road traffic information cannot be trusted, it is possible to handle both the reception of the road traffic information and the follow-up operation.

According to the present invention, it is possible to provide a multiplex broadcast receiving apparatus and a multiplex broadcast receiving method, which are capable of handling both the follow-up operation and the reception of the traffic information.

### BRIEF DESCRIPTION OF THE DRAWINGS

Fig. 1 shows the baseband coding structure of RDS data;
Fig. 2 shows the baseband coding structure in a group 8A;
Fig. 3 shows the baseband coding structure in a group 3A;
Fig. 4 is a block diagram of a multiplex broadcast receiving apparatus according to an embodiment of the present invention;
Fig. 5 shows an example of 8A data interval in accordance with gap data and the execution time of an automatic follow-up operation;
Figs. 6A and 6B show RDS data in a gap 3 and the operation timing of a sub-tuner 5;
Figs. 7A and 7B show RDS data in the gap 3 and the operation timing of the sub-tuner 5;
Figs. 8A and 8B show RDS data in the gap 3 and the operation timing of the sub-tuner 5;
Figs. 9A and 9B show RDS data in the gap 3 and the operation timing of the sub-tuner 5;
Figs. 10A and 10B show RDS data in the gap 3 and the operation timing of the sub-tuner 5;
Fig. 11 is an operation flowchart of a control section in the multiplex broadcast receiving apparatus according to the embodiment of the present invention;
Fig. 12 is an operation flowchart of the control section in the multiplex broadcast receiving apparatus according to the embodiment of the present invention;
Fig. 13 is a processing flowchart for checking tuning information for an FM broadcast;
Fig. 14 is a processing flowchart for changing an alternative frequency by the control section;
Fig. 15 is a processing flowchart of a station selection operation in the sub-tuner;
Fig. 16 is a processing flowchart for generating station list data;
Fig. 17 is a processing flowchart for analyzing RDS data in the sub-tuner;
Fig. 18 is a processing flowchart for analyzing a block 2 of the RDS data;
Fig. 19 is a processing flowchart for analyzing a block 3 of the RDS data; and
Fig. 20 is a processing flowchart for analyzing a block 4 of the RDS data.

### DESCRIPTION OF THE PREFERRED EMBODIMENTS

Preferred embodiments of the present invention will now be described below.

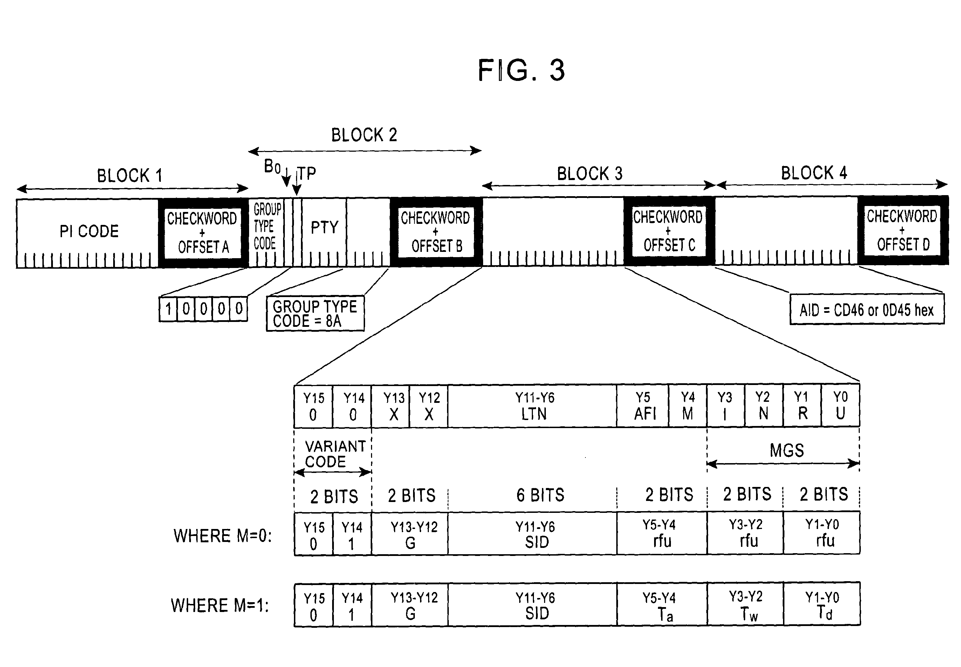

An embodiment of the present invention is described below. First, the baseband coding structure of a group 3A for transmitting a TMC is described with reference to Fig. 3. Fig. 3 shows the baseband coding structure in a group 3A. The data of the group 3A and the data of a group 8A are TMC data, and the data of the group 3A shows meticulous content associated with the data of the group 8A. As shown in Fig. 3, a block 1 has a PI code. A block 2 has a group type code, a TP code, and a PTY code.

A block 3 has a variant code, a location table number (LTN), an alternative frequency indicator (AFI), a transmission mode M, a message geographical scope (MGS), a gap parameter G, and an service identifier (SID). In the message geographical scope MGS, I indicates an international broadcast, N indicates a national broadcast, R indicates a regional broadcast, and U indicates an urban broadcast.

The gap parameter G (hereinafter referred to as "gap data") indicates the interval (the transmission interval of the road traffic information) between the data of the group 8A, and the data of the group 8A, which is transmitted next. In the RDS, four types of gap parameters in which this interval is 3, 5, 8, or 11, are provided. In a multiplex broadcast receiving apparatus 1 according to this embodiment, the interval between the data of the group 8A is sent and the data of the next group 8A is sent is understood by using the four types of gap parameters. That is, since the transmission interval of the TMC data can be taken in the group 3A, the data of the group 8A is received in accordance with the gap data G contained in the data of the group 3A, and during the period of the gap, a station auto find system (SAFS) is performed.

Next, a description is given in detail of the configuration of the multiplex broadcast receiving apparatus according to this embodiment.

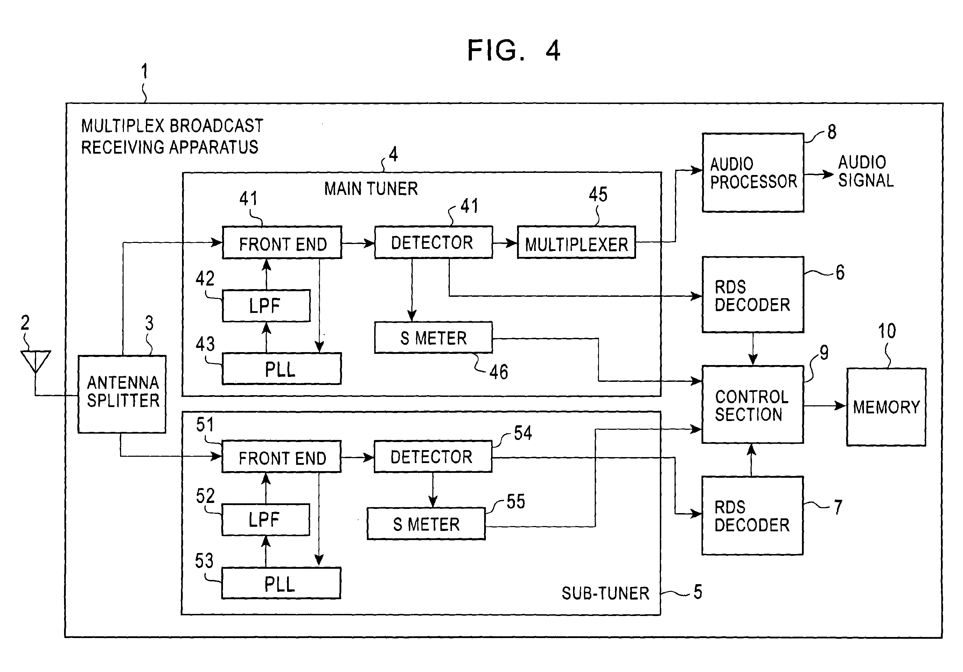

Fig. 4 is a block diagram of the multiplex broadcast receiving apparatus 1 according to the embodiment. As shown in Fig. 4, the multiplex broadcast receiving apparatus 1 includes a receiving antenna 2, an antenna splitter 3, a main tuner 4, a sub-tuner 5, RDS decoders 6 and 7, an audio processor 8, and a control section 9. The multiplex broadcast receiving apparatus 1 receives a multiplexed broadcast wave from each broadcast station.

This multiplex broadcast receiving apparatus 1 includes two tuners. While the main tuner 4 receives a multiplexed broadcast wave containing a program broadcast and data multiplexed with this program broadcast, the sub-tuner 5 checks the state in which the alternative frequency of the same program broadcast as that which is being received by the main tuner 4 is received, so that the main tuner 4 follows up on the alternative frequency at which the receiving state is satisfactory.

The receiving antenna 2 receives a multiplexed broadcast wave containing the program broadcast that is broadcast from a plurality of broadcast stations, and RDS data multiplexed with the program broadcast. The antenna splitter 3 splits the multiplexed broadcast wave received by the receiving antenna 2 to the main tuner 4 and the sub-tuner 5. The main tuner 4 receives the program broadcast multiplexed with the multiplexed broadcast wave via the receiving antenna 2 in accordance with a control signal from the control section 9. This main tuner 4 includes a front end 41, a low-pass filter (LPF) 42, a PLL circuit 43, a detector 44, a multiplexer 45, and an S meter 46.

The front end 41 selects a desired station from the multiplexed broadcast received via the receiving antenna 2 and the antenna splitter 3, converts the received frequency of this station into an intermediate frequency, and amplifies it. Also, the front end 41 oscillates a local oscillation frequency for detecting a desired broadcast wave to be received by the main tuner 4. The PLL circuit 43 obtains the local oscillation frequency output from the front end 41 and outputs an error signal to the low-pass filter 42. The low-pass filter 42 extracts only the low-frequency components from the error signal output from the PLL circuit 43 and outputs a tuning voltage to the front end 41.

The detector 44 detects the intermediate frequency signal amplified by the front end 41. The multiplexer 45 demodulates the detection output signal of the detector 44 into an audio signal, and separates the audio signal into audio signals of L (left) and R (right) channels in the case of a stereo broadcast. The output end of the multiplexer 45 is connected to the audio processor 8. The S meter 46 detects the electric-field strength of the signal that is being received from the detection signal of the detector 44. The data of the electric-field strength detected by the S meter 46 is output to the control section 9.

The sub-tuner 5 receives the data (road traffic information) of the group 8A, multiplexed with the multiplexed broadcast wave, which is transmitted at a predetermined interval, via the receiving antenna 2 in accordance with the control signal from the control section 9. This sub-tuner 5 includes a front end 51, a low-pass filter 52, a PLL circuit 53, a detector 54, and an S meter 55. The front end 51 sequentially receives the alternative frequency from the multiplexed broadcast received via the receiving antenna 2 and the antenna splitter 3 on the basis of an alternative frequency list (AF list), converts the received frequency into an intermediate frequency, and amplifies it. Also, the front end 51 oscillates a local oscillation frequency for detecting a desired broadcast wave to be received by the sub-tuner 5.

The PLL circuit 53 obtains the local oscillation frequency from the front end 51, and outputs an error signal to the low-pass filter 52. The low-pass filter 52 extracts only the low-frequency components from the error signal output from the PLL circuit 53 and outputs a tuning voltage to the front end 51. The detector 54 detects the intermediate frequency amplified by the front end 51. The S meter 55 detects the electric-field strength of the signal which is being received from the detected output signal of the detector 54. The data of the electric-field strength detected by the S meter 55 is output to the control section 9. The main tuner 4 corresponds to the first tuner, and the sub-tuner 5 corresponds to the second tuner.

The RDS decoders 6 and 7 function to extract L-MSK modulation signal components from the signal detected by the detectors 44 and 54, modulate the L-MSK modulation signal, and output a bit sequence (containing the RDS data). The RDS data is output to the control section 9. This RDS data contains data, such as an alternative frequency (AF) list indicating the frequencies of the broadcast stations that broadcast the same program, a program identification (PI) code, and a program type (PTY) code indicating the content of the program. The alternative frequency list, the program identification code, and the like obtained from the RDS data are stored in a memory 10, which is connected to the control section 9.

When creating the AF list, the RDS decoder 7 extracts the AF list for broadcasting the same program as that of the broadcast station, which is being received by the main tuner 4, from the RDS data in accordance with the PI code. The audio processor 8 performs predetermined signal processing and outputs an audio signal.

The control section 9, which is formed by, for example, a microcomputer, performs various control, such as station selection control in accordance with a station selection operation, control of an automatic follow-up operation, and AF list creation control. This control section 9 concurrently performs an automatic follow-up operation and obtains TMC information while controlling the main tuner 4 and the sub-tuner 5. That is, in a state in which the main tuner 4 is receiving a multiplexed broadcast, the control section 9 outputs a selection instruction to the PLL circuit 53 in accordance with the AF list of the broadcast station of the same program as that which is being received by the main tuner 4, the AF list being stored in the memory 10. This enables the sub-tuner 5 to sequentially receive the alternative frequency at which the same program is being broadcast. A determination is made as to whether or not the receiving state of the received frequency is better than the receiving state of the frequency being received by the main tuner 4 on the basis of the electric-field strengths detected by the S meters 46 and 55 of the main tuner 4 and the sub-tuner 5. The control section 9 enables the PLL circuit 43 to perform a follow-up operation so that the main tuner 4 tunes to the alternative frequency which is determined to be satisfactory.

The follow-up operation of the control section 9 is performed in accordance with the transmission interval of the data (road traffic information) of the group 8A. Furthermore, the control section 9 changes the timing of the follow-up operation in accordance with the obtained gap data G. For the gap data obtained by the control section 9, there are four kinds of intervals between the data of the group 8A and the data of the subsequent group 8A, that is, 3, 5, 8, and 11. The control section 9 receives the data of the group 8A at the interval in accordance with each of the gap data, and shifts to the follow-up operation immediately when the data of the group 8A is obtained. That is, the control section 9 changes the time period at which the follow-up operation is performed in accordance with the transmission interval of the data (road traffic information) of the group 8A.

When the data of the group 8A, which should have been sent by a predetermined rule, is not obtained, the control section 9 waits for a predetermined time at that station. When the state in which the data of the group 8A, which should have been sent by a predetermined rule, continues a plurality of times, by assuming that the gap data sent from the broadcast station cannot be trusted, the control section 9 repeats the reception of the data of the group 8A and the automatic follow-up operation at a fixed interval. That is, when the data of the group 8A cannot be received for a predetermined period of time by the sub-tuner 5, the control section 9 enables the sub-tuner 5 to repeat the reception of the data of the group 8A and the automatic follow-up operation at a predetermined interval. Then, when the gap data is obtained again, the operation in accordance with the gap data is performed. Depending on the operating state, the control section 9 may enable the main tuner 4 to obtain the TMC data and may enable the sub-tuner 5 to be dedicated to performing an automatic follow-up operation. The control section 9 corresponds to the control section in the claims.

Next, the operation of the control section 9 is described briefly. Initially, after the power is switched on, the control section 9 enables the sub-tuner 5 to perform an automatic follow-up operation, so that a list is created (the obtainment of the PS data is included). At the same time, the control section 9 detects the TMC station and obtains the gap data contained in the group 3A during the scanning. After the scanning, the control section 9 obtains the gap data G contained in the data of the group 3A at a maximum of three seconds with respect to the TMC station in which the receiving state is best or the TMC station specified by the connected navigation apparatus. The control section 9 changes the operation interval and the PS obtaining interval after the obtainment in accordance with the number of gaps indicated by the gap data G.

Next, a description is given of the transmission interval of the data of the group 8A in accordance with the gap data, and the execution time of the automatic follow-up operation.

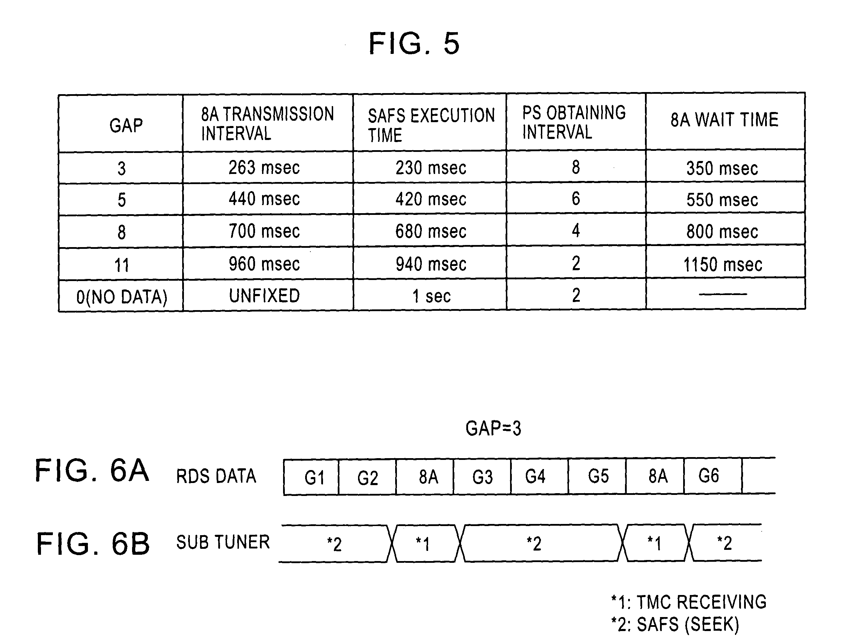

Fig. 5 shows an example of the transmission interval of the data of the group 8A in accordance with the gap data and the execution time of an automatic follow-up operation. As shown in Fig. 5, when the gap is "3", the transmission interval of the data of the group 8A is 263 msec. Therefore, the control section 9 sets the execution time of the automatic follow-up operation in the sub-tuner 5 to 230 msec, the PS obtaining interval to "8", and the wait time for the data of the group 8A to 350 msec.

When the gap is "5", the transmission interval of the data of the group 8A is 440 msec. Therefore, the control section 9 sets the execution time of the automatic follow-up operation in the sub-tuner 5 to 420 msec, the PS obtaining interval to "6", and the wait time for the data of the group 8A to 550 msec. When the gap is "8", the transmission interval of the data of the group 8A is 700 msec. Therefore, the control section 9 sets the execution time of the automatic follow-up operation to 680 msec, the PS obtaining interval to "4", and the wait time of the data of the group 8A to 800 msec. When the gap is "11", the transmission interval of the data of the group 8A is 960 msec. Therefore, the control section 9 sets the execution time of the automatic follow-up operation to 940 msec, the PS obtaining interval to "2", and the wait time for the data of the group 8A to 1150 msec.

The control section 9 performs the alternative frequency switching operation (AF switching) during the execution time of the permitted automatic follow-up operation. The control section 9 does not permit the reception of the TMC station while the PS is obtained in the automatic follow-up operation, and performs the reception of the TMC station after the PS is obtained. When the data of the group 3A is received instead of the data of the group 8A, thereafter, the control section 9 performs operations in accordance with the gap data G contained in the data of the group 3A. In a case where the operation in accordance with the gap data G is being performed, the control section 9 cancels the operation in accordance with the gap data G when data other than that of the group 8A and the group 3A is received continuously a predetermined number of times, for example, five times.

Next, a description is given of control in accordance with the mode in the control section 9. After the power is switched on, the control section 9 enables the sub-tuner 5 to start down-seeking from, for example, 108.0 MHz in order to select a receivable broadcast station and to obtain the PI code. After the seeking is completed, by using the sub-tuner 5, the control section 9 performs a scanning operation for a maximum of three seconds with respect to the receivable broadcast station for which the PI code can be obtained. When the PS data can be obtained within the three seconds, the control section 9 enables the sub-tuner 5 to shift to the next receivable broadcast station.

The control section 9 enables the sub-tuner 5 to obtain the PS and AF data and also to confirm the TMC station during the scanning (8A, 3A, and 1A data transmission). In order to obtain the gap data G contained in the data of the group 3A, the control section 9 enables the sub-tuner 5 to receive the TMC station in which the receiving state is best or the TMC station specified by the navigation apparatus at a maximum of three seconds. When the gap data G can be obtained within the three seconds in the sub-tuner 5, the control section 9 shifts to the next operation.

After the gap data G is obtained, the control section 9 shifts from mode 1 to mode 4. Here, the modes 1 to 4 are described briefly. The mode 1 is a mode in the case of a TMC station which is not desired by the main tuner 4. The mode 2 is a mode in the case of a TMC station which is desired by the main tuner 4. The mode 3 is a mode in the case where the main tuner 4 receives an AM broadcast. The mode 4 is a mode other than a tuner.

The mode 1 (mode in the case of a TMC station which is not desired by the main tuner 4) is described below. In the following, cases in which the gap data G cannot be detected (gap = 0), the number of gaps is 3 (gap = 3), the number of gaps is 5 (gap = 5), the number of gaps is 8 (gap = 8), and the number of gaps is 11 (gap = 11) are described.

First, the case in which the gap data G contained in the data of the group 3A cannot be detected (gap = 0) is described. When the gap data of the group 3A cannot be detected by the sub-tuner 5, since the interval at which the data of the group 8A is sent is unknown, the control section 9 sets the interval at which the TMC station is checked is set to, for example, one second. After mode 0, the control section 9 enables the sub-tuner 5 to perform an automatic follow-up operation for one second and to perform the reception of the TMC station for one second. That is, when the gap data cannot be detected and the transmission interval of the road traffic information is not known, the control section 9 enables the sub-tuner 5 to repeatedly perform the reception of the data of the group 8A and to check the receiving state in the follow-up operation at a predetermined interval.

When the data of the group 8A is being received when one second has elapsed while the TMC station is being received by the sub-tuner 5, the control section 9 continues the reception of the data of the group 8A and shifts to the automatic follow-up operation after the reception of the data of the group 8A is completed. When the PI (program identification) data is being analyzed in the automatic follow-up operation of the sub-tuner 5, even when the gap is exceeded, the control section 9 continues the analysis of the PI. When a maximum of 250 msec for PI analysis is terminated, the control section 9 shifts to the reception of the TMC station. The control section 9 performs the scanning operation for obtaining the PS in the sub-tuner 5 at every two automatic follow-up operations.

Next, the case in which the number of gaps is "3" (gap = 3) is described.

Figs. 6A and 6B, Figs. 7A and 7B, and Figs. 8A and 8B show RDS data in the gap 3 and the operation timing of the sub-tuner 5. Figs. 6A, 7A, and 8A show the RDS data. Figs. 6B, 7B, and 8B show the operation timing of the sub-tuner 5. In Fig. 6A, reference character G denotes a gap, and 8A denotes the data of the group 8A. Between the data of the group 8A and the data of the next group 8A, three gaps of G3, G4, and G5 are inserted.

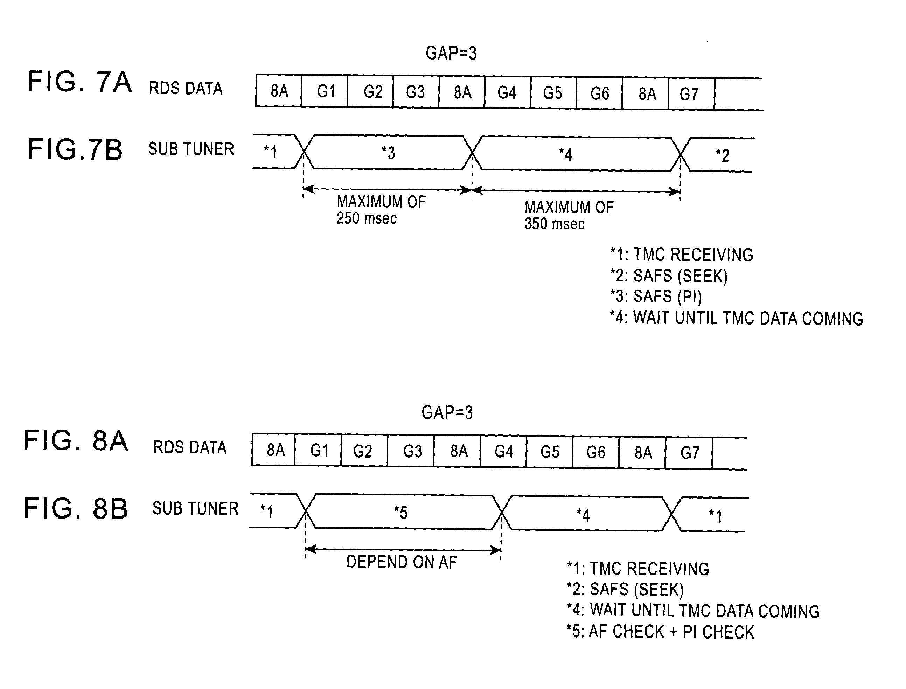

The sub-tuner 5 receives the TMC station during the period of the symbol (*1) shown in Fig. 6A, performs an automatic follow-up operation during the period of the symbol (*2), performs PI analysis in the automatic follow-up operation during the period of the symbol (*3) shown in Fig. 7B, waits for the TMC data to arrive during the period of the symbol (*4), and performs alternative frequency (AF) checking and PI checking during the period of the symbol (*5) shown in Fig. 8B.

After the mode 0, the control section 9 enables the sub-tuner 5 to perform an automatic follow-up operation of the specified execution time (*2) and to receive the TMC station (*1). The control section 9 enables the sub-tuner 5 to start a synchronization process and to shift to the automatic follow-up operation when the data of the group 8A can be received. The control section 9 enables the sub-tuner 5 to perform an automatic follow-up operation of the specified execution time and to receive the TMC station again. Furthermore, as shown in Figs. 7A and 7B, when PI analysis is performed in the automatic follow-up operation in the sub-tuner 5, the TMC station is received after a maximum of 250 msec. However, since the transmission interval of the data of the group 8A is exceeded, the control section 9 continues the reception until the data (TMC data) of the next group 8A is received (*4).

As shown in Figs. 8A and 8B, when the control section 9 checks the alternative frequency in the automatic follow-up operation of the sub-tuner 5 and switches the main tuner 4 to the alternative frequency, the necessary time varies depending on the number of alternative frequencies (number of AF) of the alternative frequency list. When the TMC station is received after the checking of the alternative frequency and the switching to the alternative frequency are completed, the control section 9 continues the reception until the data of the next group 8A is received (*4). The control section 9 performs the scanning operation for obtaining the PS in the sub-tuner 5 at every eight automatic follow-up operations.

Next, the case in which the number of gaps is "5" (gap = 5) is described.

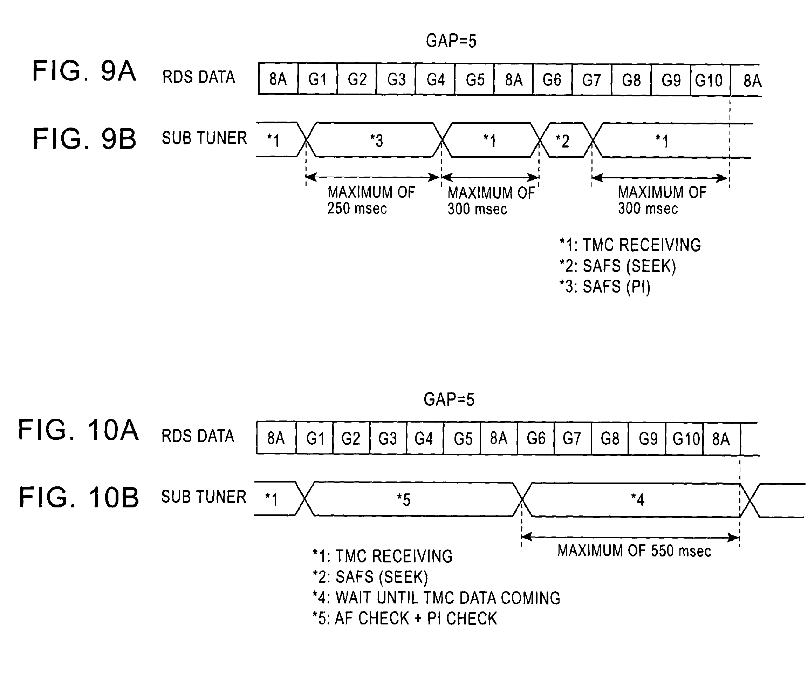

Figs. 9A and 9B, and Figs. 10A and 10B show RDS data in the gap 5 and the operation timing of the sub-tuner 5. Figs. 9A and 10A show the RDS data. Figs. 9B and 10B show the operation timing of the sub-tuner 5. As shown in Fig. 9A, between the data of the group 8A and the data of the next group 8A, five gaps of G1, G2, G3, G4, and G5 are inserted. Reference characters (*1) to (*5) are identical to those shown in Figs. 6A to 8B, and accordingly, descriptions thereof are omitted here.

After the mode 0, the control section 9 enables the sub-tuner 5 to perform an automatic follow-up operation for the specified execution time in order to receive the TMC station. The control section 9 enables the sub-tuner 5 to start a synchronization process, and when the data of the group 8A can be received, the control section 9 shifts to the automatic follow-up operation. The control section 9 enables the sub-tuner 5 to perform the automatic follow-up operation for the specified execution time in order to receive the TMC station again.

As shown in Figs. 9A and 9B, when PI analysis is performed in the automatic follow-up operation in the sub-tuner 5, the control section 9 shifts to PI analysis (*3) when the actual time of the permitted automatic follow-up operation remains 250 msec or more, and shifts to the reception of the TMC station when the actual time does not remain 250 msec or more (*1).

As shown in Figs. 10A and 10B, when the control section 9 checks the alternative frequency in the automatic follow-up operation in the sub-tuner 5 and switches the main tuner 4 to the alternative frequency, the necessary time varies depending on the number of alternative frequencies of the alternative frequency list. When the TMC station is received after the checking of the alternative frequency and the switching of the main tuner 4 to the alternative frequency are completed, the control section 9 continues the reception until the data of the next group 8A is received. The control section 9 performs the scanning operation for obtaining the PS in the sub-tuner 5 at every six automatic follow-up operations.

Next, the case in which the number of gaps is "8" (gap = 8) is described. After the mode 0, the control section 9 enables the sub-tuner 5 to perform an automatic follow-up operation for the specified execution time in order to receive the TMC station. The control section 9 enables the sub-tuner 5 to start a synchronization process, and when the data of the group 8A can be received, the control section 9 shifts to the automatic follow-up operation. The control section 9 enables the sub-tuner 5 to perform the automatic follow-up operation for the specified execution time in order to receive the TMC station again.

When PI analysis is performed in the automatic follow-up operation in the sub-tuner 5, the control section 9 shifts to PI analysis when the actual time of the permitted automatic follow-up operation remains 250 msec or more, and shifts to the reception of the TMC station when the actual time does not remain 250 msec or more. When the control section 9 checks the alternative frequency and switches the main tuner 4 to the alternative frequency in the automatic follow-up operation in the sub-tuner 5, the necessary time varies depending on the number of alternative frequencies of the alternative frequency list. When the TMC station is received after the checking of the alternative frequency and the switching to the alternative frequency are completed, the control section 9 continues the reception until the data of the next group 8A is received. The control section 9 performs the scanning operation for obtaining the PS in the sub-tuner 5 at every four automatic follow-up operations.

Next, the case in which the number of gaps is "11" (gap = 11) is described. After the mode 0, the control section 9 enables the sub-tuner 5 to perform an automatic follow-up operation for the specified execution time in order to receive the TMC station. The control section 9 enables the sub-tuner 5 to start a synchronization process, and when the data of the group 8A can be received, the control section 9 shifts to the automatic follow-up operation. The control section 9 enables the sub-tuner 5 to perform the automatic follow-up operation for the specified execution time in order to receive the TMC station again.

When PI analysis is performed in the automatic follow-up operation of the sub-tuner 5, the control section 9 shifts to PI analysis when the actual time of the permitted automatic follow-up operation remains 250 msec or more, and shifts to the reception of the TMC station when the actual time does not remain 250 msec or more. When the control section 9 checks the alternative frequency and switches the main tuner 4 to the alternative frequency in the automatic follow-up operation of the sub-tuner 5, the necessary time varies depending on the number of alternative frequencies in the alternative frequency list. When the TMC station is received after the checking of the alternative frequency and the switching of the main tuner 4 to the alternative frequency are completed, the control section 9 continues the reception until the data of the next group 8A is received. The control section 9 performs the scanning operation for obtaining the PS in the sub-tuner 5 at every two automatic follow-up operations.

Next, the mode 2 (mode in the case of a TMC station which is desired by the main tuner 4) is described. The control section 9 enables the sub-tuner 5 to perform only the automatic follow-up operation and enables the main tuner 4 to obtain data on the TMC.

Next, the mode 3 (the case where the main tuner 4 receives an AM broadcast) is described. The control section 9 enables the sub-tuner 5 to perform an operation in accordance with the mode 1, and further confirms TP/TA with respect to the TA station at a maximum of 250 msec. The control section 9 sets the interval at which TP/TA confirmation is performed in the sub-tuner 5 to one second.

Next, the mode 4 (the case of the mode other than a tuner) is described. The control section 9 performs an operation in accordance with the mode 2, and further confirms TP/TA with respect to the TA station at a maximum of 250 msec. The control section 9 performs the confirmation at every second.

Next, a description is given of the detailed operation of the multiplex broadcast receiving apparatus 1 according to this embodiment.

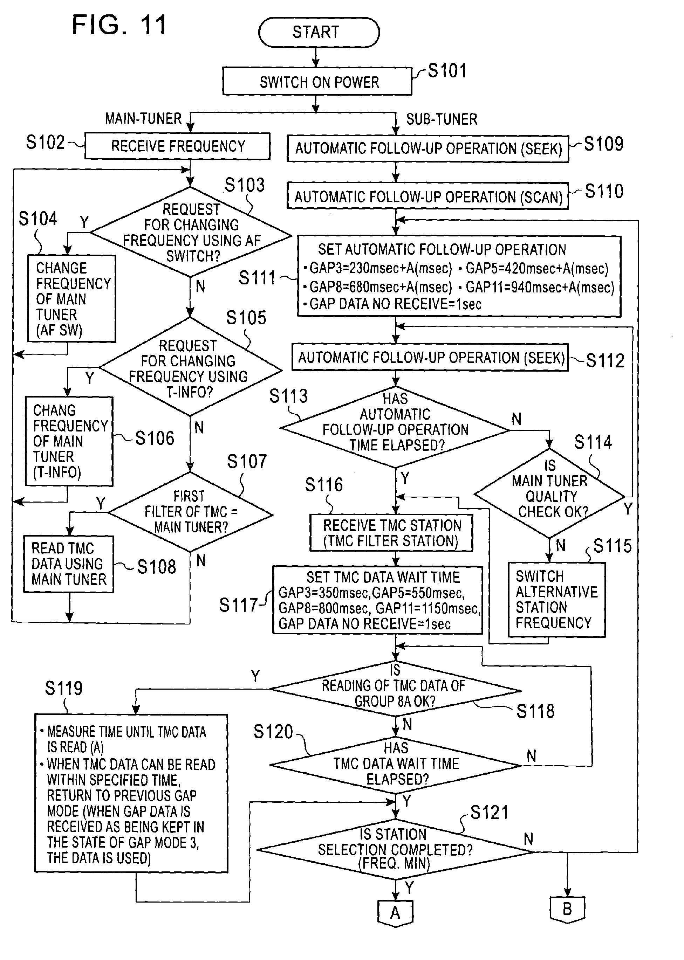

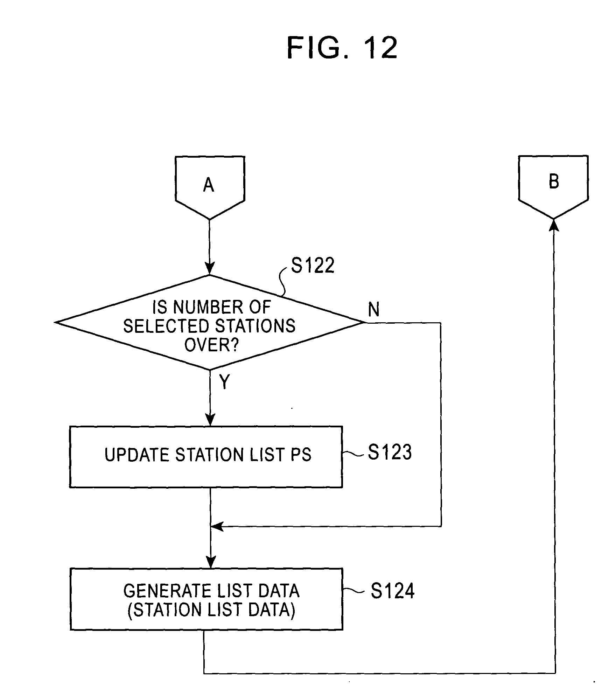

Figs. 11 and 12 are operation flowcharts of the control section 9 of the multiplex broadcast receiving apparatus 1 according to this embodiment. When the power is switched on in step S101, the control section 9 controls the main tuner 4 in steps S102 to S108 and controls the sub-tuner 5 in steps S109 to S124. The main tuner 4 side is described first. In step S102, the control section 9 enables the main tuner 4 to receive the most current frequency. In step S103, the control section 9 checks whether or not there is a frequency change request based on alternative frequency switching (AF switching) in the main tuner 4. When there is a frequency change request, in step S104, the receiving frequency of the main tuner 4 is changed.

When there is no frequency change request based on alternative frequency switching in step S103, the control section 9 checks in step S105 whether or not there is a frequency change request based on tuning information (T-INFO). When there is a frequency change request based on tuning information, in step S106, the receiving frequency of the main tuner 4 is changed. When there is no frequency change request in step S105, if the first filter of the TMC is the main tuner 4 in step S107, the main tuner 4 reads the TMC data in step S108.

Next, the sub-tuner 5 side is described. In step S109, the control section 9 enables the sub-tuner 5 to perform an automatic follow-up operation, and in step S110, a scanning is performed. In step S111, the control section 9 sets the operation time of the automatic follow-up operation as follows in accordance with the gap data G contained in the data of the group 3A.

When the gap = "3", the control section 9 sets the execution time of the automatic follow-up operation to "230 msec + A(msec)". When the gap = "5", the control section 9 sets the execution time of the automatic follow-up operation to "420 msec + A(msec)". When the gap = "8", the control section 9 sets the execution time of the automatic follow-up operation to "680 msec + A(msec)". When the gap = "11", the control section 9 sets the execution time of the automatic follow-up operation to "940 msec + A(msec)". The above-mentioned "A" can be changed as appropriate.

In step S112, the control section 9 enables the sub-tuner 5 to perform an automatic follow-up operation in accordance with the time of the automatic follow-up operation corresponding to the gap data G contained in the data of the group 3A. In step S113, the control section 9 checks whether or not the automatic follow-up operation time has elapsed in the sub-tuner 5. When the automatic follow-up operation time has elapsed, the process proceeds to step S116. When it has not elapsed, in step S114, a check is made to determine whether or not the receiving quality of the main tuner 4 is satisfactory. When the receiving quality is not satisfactory, in step S115, the receiving frequency of the main tuner 4 is changed to the alternative frequency. The process then proceeds to step S116.

In step S116, the control section 9 enables the sub-tuner 5 to receive the TMC station. In step S117, the control section 9 sets the wait time of the TMC data in the sub-tuner 5, for example, as follows in accordance with the gap data G contained in the data of the group 3A. When the gap = "3", the wait time of the 8A data is set to 350 msec. When the gap = "5", the wait time of the 8A data is set to 550 msec. When the gap = "8", the wait time of the 8A data is set to 800 msec. When the gap = "11", the wait time of the 8A data is set to 1150 msec. When there is no gap (gap = 0), the wait time of the data of the group 8A is set to one second.

In step S118, the control section 9 enables the sub-tuner 5 to analyze the RDS data, for example, at every 4 msec, so that it is checked whether or not the data of the group 8A of the TMC data could be read. When the data could be read, the process proceeds to step S119, and when the data could not be read, the process proceeds to step S120. In step S119, the control section 9 measures the time until the TMC data is read. Furthermore, when the TMC data could be read within the specified time, the control section 9 returns the mode to the previous gap mode, and the process then proceeds to step S121. However, when the gap data is received as being kept in the state of the gap mode 3, the data is used.

In step S120, the control section 9 checks whether or not the wait time for the TMC data in the sub-tuner 5 has elapsed. When the wait time for the TMC data has elapsed, the process proceeds to step S121. In step S121, the control section 9 checks whether or not the station selection has completed. When the station selection has not completed, the process returns to step S111, where the above-described processing is performed again. When the station selection has completed, the process proceeds to step S122.

In step S122, the control section 9 checks whether or not the number of selection stations is exceeded in the automatic follow-up operation of the sub-tuner 5. When the number of selection stations is exceeded in the automatic follow-up operation of the sub-tuner 5, the station list PS is updated. In step S124, the control section 9 generates list data, and the process returns to step S111, where the above-described processing is performed again.

Next, a description is given of the checking of the tuning information of an FM broadcast in the control section 9.

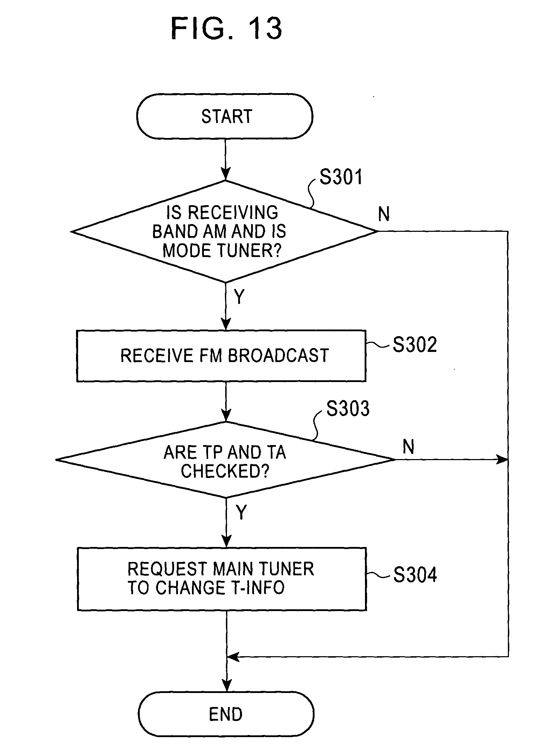

Fig. 13 is a processing flowchart for checking tuning information for an FM broadcast. In step S301, the control section 9 checks whether or not the receiving band in the main tuner 4 is AM and whether or not the mode is a tuner. When the receiving band is AM and the mode is a tuner, the process proceeds to step S302, where the main tuner 4 receives an FM broadcast. In step S303, the control section 9 checks TP and TA. Thereafter, in step S304, the control section 9 requests the main tuner 4 to change the tuning information, and the processing is then completed.

Next, a description is given of alternative frequency switching (AF switching).

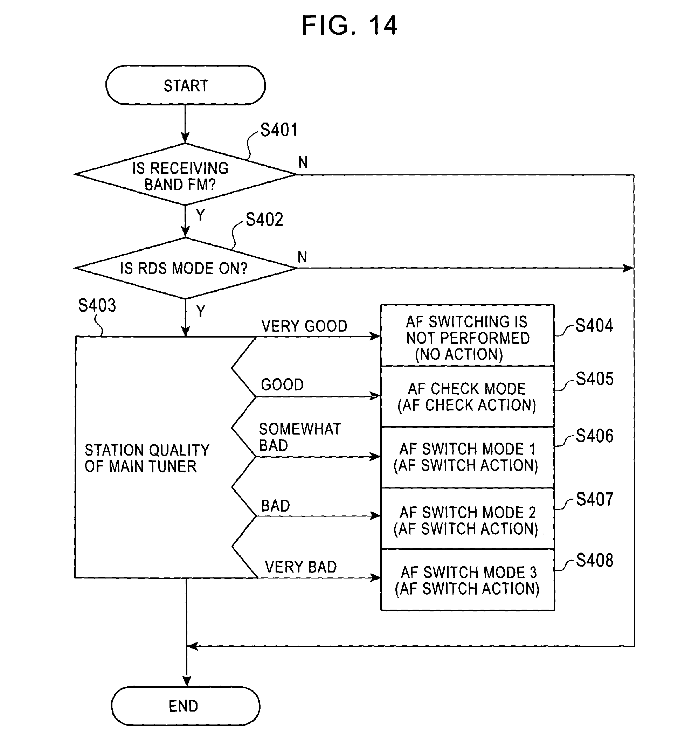

Fig. 14 is a processing flowchart for changing alternative frequency by the control section 9. In step S401, the control section 9 checks whether or not the receiving band of the main tuner 4 is an FM broadcast. When the receiving band is an FM broadcast, in step S402, it is checked whether or not the RDS mode is on. When the RDS mode is on, in step S403, the receiving quality of the broadcast station which is received by the main tuner 4 is checked. When it is determined in step SS403 that the receiving quality of the broadcast station is very good, the alternative frequency switching is not performed (step S404). When the receiving quality is good, the process proceeds to the alternative frequency check mode (step S405). When the receiving quality is somewhat bad, the process proceeds to the alternative frequency switch mode 1 (step S406). When the receiving quality is bad, the process proceeds to the alternative frequency switch mode 2 (step S407). When the receiving quality is very bad, the process proceeds to the alternative frequency switch mode 3 (step S407). Then, the processing is completed.

Next, a description is given of a station selection operation in the sub-tuner 5.

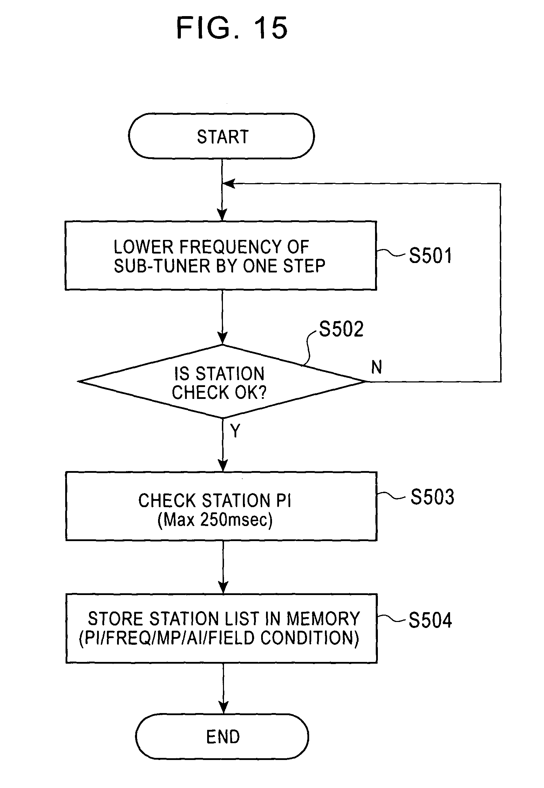

Fig. 15 is a processing flowchart of a station selection operation in the sub-tuner 5. The control section 9 creates a station list in this processing. In step S501, the control section 9 lowers the station selection frequency in the sub-tuner 5 by one step. In step S502, the control section 9 checks the station, and in the subsequent step S503, the control section 9 checks the station PI at a maximum of 250 msec. In step S504, the station list is stored in the memory 10. Here, the station list contains PI, FREQ, MP, AI, and the electric-field strength (field condition).

Next, a description is given of the generation of station list data.

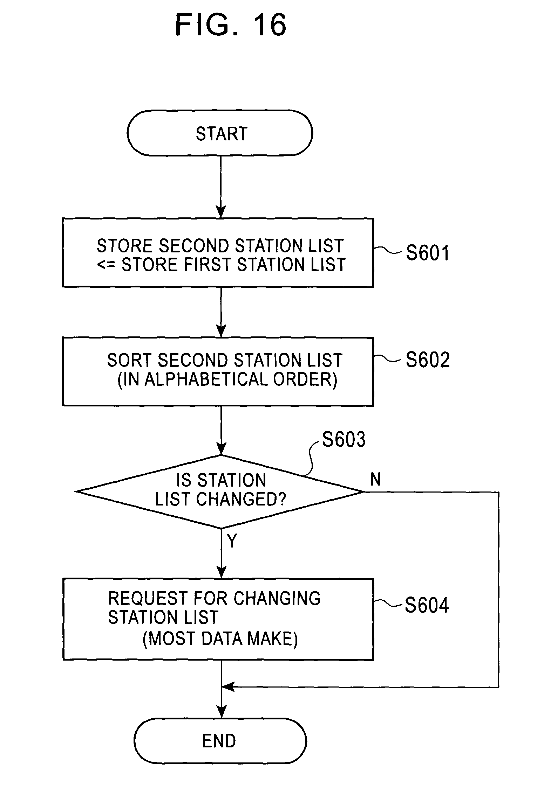

Fig. 16 is a processing flowchart for generating station list data. In step S601, the control section 9 stores a first station list in the memory 10 and then stores a second station list in the memory 10. In step S602, the control section 9 sorts the second station list in an alphabetical order. When the station list is changed in step S603, the control section 9 makes a request for changing the station list in step S604. Then, the processing is completed.

Next, a description is given of RDS data analysis in the sub-tuner 5.

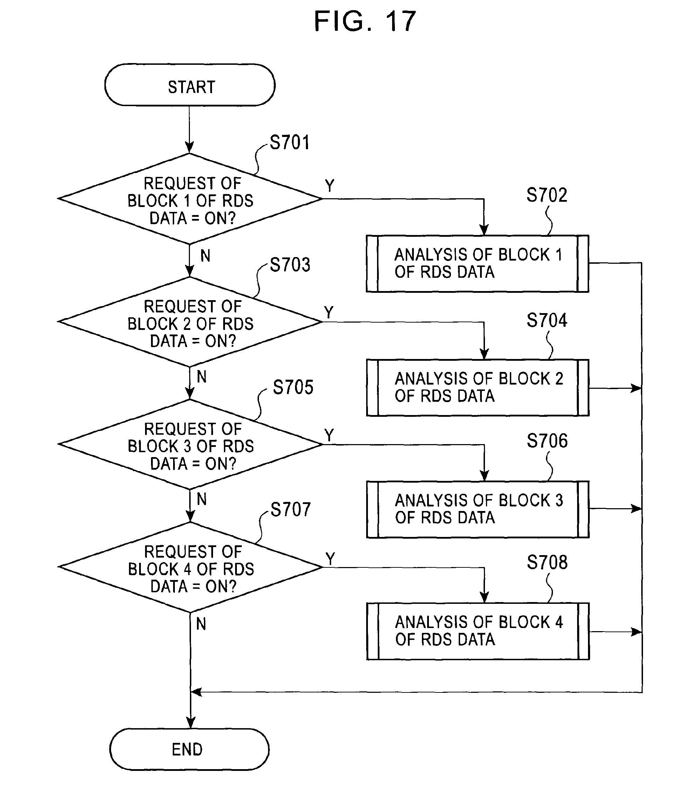

Fig. 17 is a processing flowchart for analyzing RDS data in the sub-tuner 5. In step S701, the control section 9 checks whether or not the request for the block 1 of the RDS data is on. When the request is on, in step S702, the block 1 of the RDS data is analyzed. When the request is not on, the process proceeds to step S703. In step S703, the control section 9 checks whether or not the request for the block 2 of the RDS data is on. When the request is on, the block 2 of the RDS data is analyzed, and when the request is not on, the process proceeds to step S705.

In step S705, the control section 9 checks whether or not the request for the block 3 of the RDS data is on. When the request is on, in step S706, the block 3 of the RDS data is analyzed. When the request is not on, the process proceeds to step S707. When the request for a block 4 of the RDS data is on in step S707, the block 4 of the RDS data is analyzed in step S708. When the request is not on, the processing is completed.

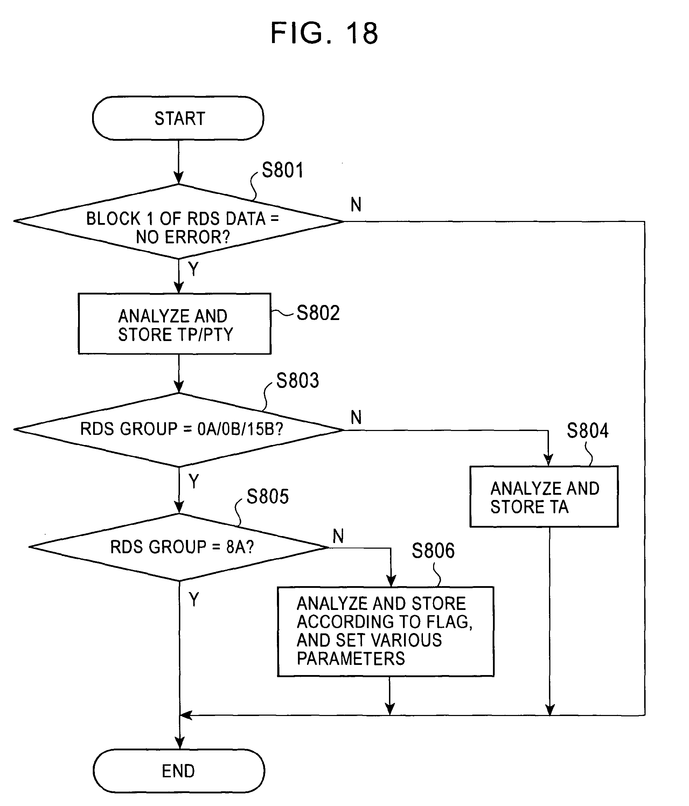

Next, a description is given of a process for analyzing the block 2 of the RDS data in the sub-tuner 5. Fig. 18 is a processing flowchart for analyzing the block 2 of the RDS data. In step S801, the control section 9 checks whether or not there is an error in the block 1 of the RDS data. When there is no error, in step S802, TP and PTY are analyzed, and these are stored in the memory 10.

In step S803, the control section 9 checks whether or not the RDS group is 0A, 0B, or 15B. When the RDS group does not correspond to any one of these, in step S804, the control section 9 analyzes TA and stores this TA in the memory 10. When the RDS group corresponds to 0A, 0B, or 15B, in step S805, the control section 9 checks whether or not the RDS group is a group 8A. When the RDS group is a group 8A, the processing is completed. When the RDS group is not a group 8A, the control section 9 performs analysis and storage according to the flag in step S806.

Next, a description is given of a process for analyzing the block 3 of the RDS data in the sub-tuner 5.

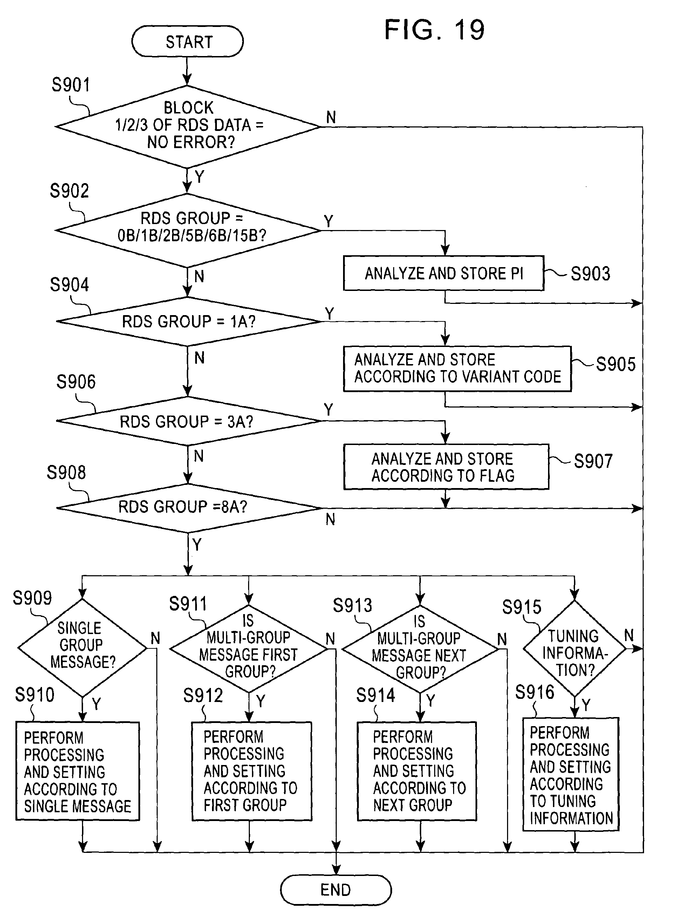

Fig. 19 is a processing flowchart for analyzing the block 3 of the RDS data in the sub-tuner 5. In step S901, the control section 9 checks whether or not the RDS data blocks 1, 2, and 3 have an error. In step S902, the control section 9 checks whether or not the RDS group is 0B, 1B, 2B, 5B, 6B, or 15B. When the RDS group corresponds to 0B, 1B, 2B, 5B, 6B, or 15B, in step S903, the control section 9 analyzes the PI code and stores this PI code. When the RDS group does not correspond to 0B, 1B, 2B, 5B, 6B, or 15B, the process proceeds to step S904.

In step S904, the control section 9 checks whether or not the RDS group is 1A. When the RDS group is 1A, in step S905, the control section 9 performs an analysis in accordance with a variant code and stores the analyzed result in the memory 10. When the RDS group is not 1A, the process proceeds to step S906.

In step S906, the control section 9 checks whether or not the RDS group is 3A. When the RDS group is 3A, the control section 9 performs an analysis in accordance with a flag and stores the analyzed result in the memory 10. When the RDS group is not 3A, the process proceeds to step S908.

In step S908, the control section 9 checks whether or not the RDS group is 8A. When the RDS group is 8A, if it is a single message in step S909, processing and setting according to the single message are performed in step S910. When a multi-group message is a first group in step S911, processing and setting according to the first group are performed in step S912. When the multi-group message is the next group in step S913, processing and setting according to the next group are performed in step S914. When the multi-group message is tuning information in step S915, processing and setting according to the tuning information are performed in step S916.

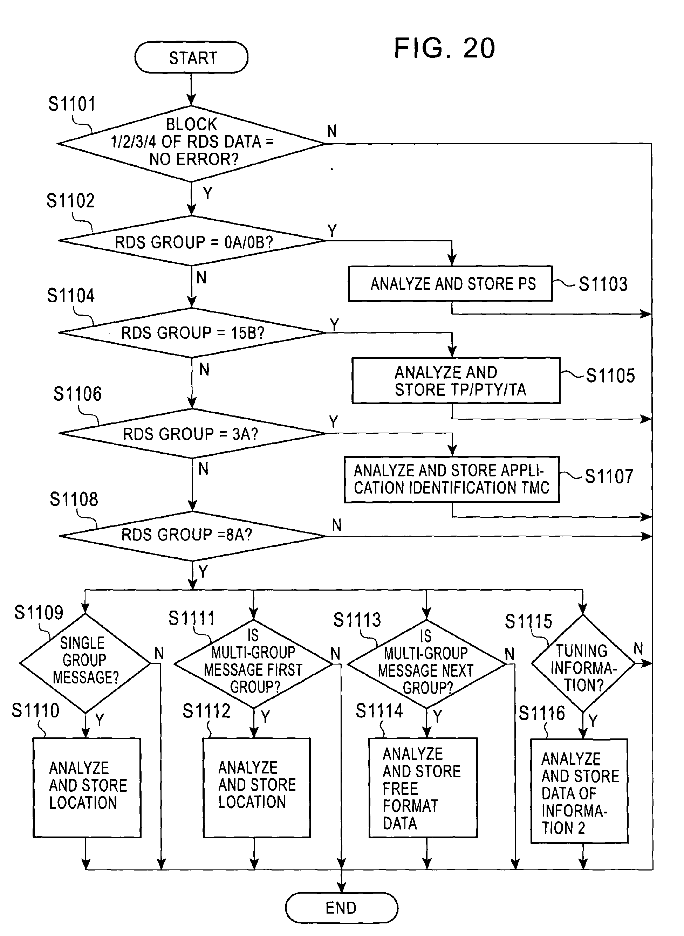

Next, a description is given of a process for analyzing the block 4 of the RDS data in the sub-tuner 5. Fig. 20 is a processing flowchart for analyzing the block 4 of the RDS data in the sub-tuner 5. In step S1101, the control section 9 checks whether or not the blocks 1, 2, 3, and 4 of the RDS data have an error.

When there is no error in step S1101, a check is made in step S1102 to determine whether or not the RDS group is 0A or 0B When the RDS group is 0A or 0B, the PS is analyzed and stored in step S1103. When the RDS group is not 0A or 0B in step S1102, the process proceeds to step S1104.

In step S1104, the control section 9 checks whether or not the RDS group is 15B. When the RDS group is 15B, in step S1105, TP, PTY, and TA are analyzed and stored. When the RDS group is not 15B, the process proceeds to step S1106.

In step S1106, a check is made to determine whether or not the RDS group is 3A. When the RDS group is 3A, in step S1107, application identification TMC is analyzed and stored. When the RDS group is not 3A in step S1106, the process proceeds to step S1108.

When the RDS group is 8A in step S1108 and when the multi-group message is a single message in step S1109, the control section 9 analyzes the location and stores it in step S1110. When the multi-group message is a first group in step S1111, the location is analyzed and stored in step S1112. When the multi-group message is the next group in step S1113, free format data is analyzed and stored in step S1114. When the multi-group message is tuning information in step S1115, data of information 2 is analyzed and stored in step S1116. The processing is then completed.

As has thus been described, according to this embodiment, since the follow-up operation is performed by the sub-tuner 5 while the road traffic information is not received, it is possible to handle both the automatic follow-up operation and the reception of the road traffic information. Since the follow-up operation is changed in accordance with the gap data, even when the transmission interval of the road traffic information is changed on the broadcast station side, it is possible to handle both the automatic follow-up operation and the reception of the road traffic information. Furthermore, when the transmission interval of the road traffic information is not known, since the sub-tuner 5 repeatedly receives the road traffic information and checks the receiving state for the follow-up operation at a predetermined interval, even when the transmission interval of the road traffic information is not known, it is possible to handle both the automatic follow-up operation and the reception of the road traffic information.

While the present invention has been described in detail with reference to the preferred embodiments, it is to be understood that the invention is not limited to the disclosed specific embodiments. On the contrary, the invention is intended to cover various modifications and equivalent arrangements included within the spirit and scope of the appended claims. The configuration of the multiplex broadcast receiving apparatus shown in Fig. 4 is only an example and is not limited to the configuration shown in the figure.

## Claims

1. A multiplex broadcast receiving apparatus (1) comprising:
a first tuner (4) for receiving a program broadcast that is multiplexed with a multiplexed broadcast wave;
a second tuner (5) for receiving road traffic information, multiplexed with said multiplexed broadcast wave, which is transmitted at a predetermined interval; and
a control section (9) for enabling said second tuner (5) to check a state in which an alternative station frequency of the same program broadcast as that which is being received by said first tuner (4) is received in accordance with the transmission interval of said road traffic information and for enabling said first tuner (4) to follow up on an alternative station frequency at which the receiving state is satisfactory.

2. The multiplex broadcast receiving apparatus (1) according to Claim 1, wherein said control section (9) obtains gap data indicating the transmission interval of said road traffic information and changes said follow-up operation in accordance with the gap data.

3. The multiplex broadcast receiving apparatus (1) according to one of Claims 1 and 2, wherein, when the transmission interval of said road traffic information is not known, said control section (9) enables said second tuner (5) to repeatedly receive said road traffic information and to check said receiving state.

4. The multiplex broadcast receiving apparatus (1) according to one of Claims 1 to 3, wherein, when the transmission interval of said road traffic information is exceeded while program identification data is being analyzed by said second tuner (5) during said follow-up operation, said control section (9) continues to enable said second tuner (5) to receive said road traffic information until the next road traffic information is transmitted.

5. The multiplex broadcast receiving apparatus (1) according to one of Claims 1 to 4, wherein, when the follow-up operation in accordance with the transmission interval of said road traffic information is being performed, said control section (9) cancels the follow-up operation in accordance with the transmission interval of said road traffic information when data other than data on said road traffic information or the transmission interval of said road traffic information is received continuously a predetermined number of times.

6. A multiplex broadcast receiving method for use with a multiplex broadcast receiving apparatus comprising a first tuner (4) for receiving a program broadcast that is multiplexed with a multiplexed broadcast wave; a second tuner (5) for receiving road traffic information, multiplexed with said multiplexed broadcast wave, which is transmitted at a predetermined interval, said multiplex broadcast receiving method comprising:
a first step in which the first tuner (4) receives a program broadcast multiplexed with said multiplexed broadcast wave;
a second step in which said second tuner (5) receives road traffic information, multiplexed with said multiplexed broadcast wave, which is transmitted at a predetermined interval; and
a third step in which said second tuner (5) checks a state in which an alternative station frequency of the same program broadcast as that which is being received by said first tuner (4) is received in accordance with the transmission interval of said road traffic information, and said first tuner (4) follows up on an alternative station frequency at which the receiving state is satisfactory.

7. The multiplex broadcast receiving method according to Claim 6, wherein said third step comprises a step of obtaining gap data indicating the transmission interval of said road traffic information and changing said follow-up operation in accordance with the gap data.

8. The multiplex broadcast receiving method according to one of Claims 6 and 7, wherein said third step comprises a step in which, when the transmission interval of said road traffic information is not known, said second tuner (5) repeatedly receives said road traffic information and checks said receiving state at a predetermined interval.

9. The multiplex broadcast receiving method according to one of Claims 6 to 8, wherein said third step comprises a step in which, when the transmission interval of said road traffic information is exceeded while program identification data is being analyzed by said second tuner (5) during said follow-up operation, said second tuner (5) receives said road traffic information when the next road traffic information is transmitted.

10. The multiplex broadcast receiving method according to one of Claims 6 to 9, wherein said third step comprises a step in which, when the follow-up operation in accordance with the transmission interval of said road traffic information is being performed, the follow-up operation in accordance with the transmission interval of said road traffic information is cancelled when data other than data on said road traffic information or the transmission interval of said road traffic information is received continuously a predetermined number of times.
